# EUROPÄISCHE PATENTANMELDUNG

(11) **EP 1 770 785 A1**
(43) Veröffentlichungstag der Anmeldung: **04.04.2007**
(21) Anmeldenummer: 06020196.9
(22) Anmeldetag: 27.09.2006
(51) Int. Cl.: H01L 29/78, H01L 27/12, H01L 21/336, H01L 21/84, H01L 21/768, H01L 21/74, H01L 21/762, H01L 29/786

(54) **Halbleiteranordnung und Verfahren zur Herstellung einer Halbleiteranordnung**

(30) Priorität: 29.09.2005 DE 102005046624
(71) Anmelder: ATMEL Germany GmbH, 74072 Heilbronn (DE)
(72) Erfinder: Florian, Tobias, Dipl.-Ing., 70569 Stuttgart (DE); Graf, Michael, Dr., 71397 Leutenbach (DE); Schwantes, Stefan, Dr., 74080 Heilbronn (DE)
(74) Vertreter: Müller, Wolf-Christian

(57) **Zusammenfassung**

Verfahren zur Herstellung einer Halbleiteranordnung, bei dem
- ein leitfähiges Substrat (100), ein Bauelementebereich (400) und eine den Bauelementebereich (400) von dem leitfähigen Substrat (100) isolierende Isolatorschicht (200) ausgebildet wird,
- ein Graben (700) in den Bauelementebereich (400) bis zur Isolatorschicht (200) geätzt wird,
- anschließend der Graben (700) bis zum leitfähigen Substrat (100) weiter geätzt wird,
- die Wände (701) des Grabens (700) mit einem Isolationsmaterial (710) ausgebildet werden, und
- ein elektrischer Leiter (750, 755, 760) in den Graben (700) eingebracht und mit dem leitfähigen Substrat (100) leitend verbunden wird,
wobei
- vor dem Ätzen des Grabens (700) eine Schichtenfolge aus einer ersten Oxidschicht (510), einer Polysiliziumschicht (520) oberhalb der ersten Oxidschicht (510) und einer zweiten Oxidschicht (530) oberhalb der Polysiliziumschicht (520) auf den Bauelementebereich (400) aufgebracht wird.

## Beschreibung

Die vorliegende Erfindung betrifft eine Halbleiteranordnung, einen Schaltkreis und ein Verfahren zur Herstellung einer Halbleiteranordnung.

Aus der DE 102 60 616 B3 ist ein Verfahren zum Herstellen eines Halbleiterbauelements bekannt. Dabei wird eine Bauelementstruktur auf einem Wafer gebildet, wobei der Wafer ein rückseitiges Halbleitersubstrat, eine vergrabene Isolatorschicht und eine oben liegende Halbleiterschicht umfasst. Eine Ätzstoppschicht wird auf dem Wafer gebildet. Der Wafer trägt die Bauelementstruktur. Ein Fenster wird in der Ätzstoppschicht ausgebildet. Eine dielektrische Schicht wird auf der Ätzstoppschicht ausgebildet, die das darin gebildete Fenster aufweist. Danach erfolgt ein simultanes Ätzen eines ersten Kontaktloches durch die dielektrische Schicht und das Fenster bis hinunter zu dem rückseitigen Halbleitersubstrat und wenigstens eines zweiten Kontaktloches durch die dielektrische Schicht bis hinunter zu der Bauelementstruktur.

Bei der Herstellung von Halbleiterbauelementen werden SOI-Wafer oder SOI-Substrate verwendet, um eine höhere Isolation zwischen benachbarten Bauelementen in einem integriertem Schaltkreis verglichen mit Bauelementen bereitzustellen, die in Bulk-Wafer ausgebildet worden sind. SOI-Substrate sind Silizium-Wafer mit einer dünnen Schicht aus einem Oxid oder aus anderen Isolatoren, die darin vergraben ist. Bauelemente werden innerhalb einer dünnen Siliziumschicht oberhalb des vergrabenen Oxids hergestellt. Die erhöhte Isolation, die dadurch erzielt wird, kann den "Latch-Up" in CMOS-Bauelementen (CMOS: Complementary Metal Oxide Semiconductor) eliminieren und reduziert weiterhin parasitäre Kapazitäten. Zusätzlich zu der vergrabenen Oxidschicht wird häufig STI (Shallow Trench Isolation) verwendet, um Transistoren oder andere Bauelemente lateral voneinander vollständig zu isolieren.

Da das rückwärtige Siliziumsubstrat von den Bauelementen mittels des vergrabenen Oxids vollständig entkoppelt ist, tendiert das Potential des Rückseitensubstrats zum Floaten während des Betriebs des Schaltkreises. Dies kann elektrische Eigenschaften des Schaltkreises beeinflussen und die Betriebszuverlässigkeit reduzieren.

Um zu verhindern, dass das rückwärtige Siliziumsubstrat des Bauelementes floatet, werden spezielle Kontakte gebildet, um das Rückseitensubstrat mit einer Metallschicht zu verbinden, die ein definiertes Potential aufweist. Zunächst wird von einer SOI-Struktur ausgegangen, die ein rückwärtiges Siliziumsubstrat, eine vergrabene Oxidschicht und eine oben liegende Siliziumschicht umfasst. Transistorstrukturen sind über der SOI-Struktur gebildet. Die oben liegende Siliziumschicht weist geätzte mit STI-Material gefüllte Isolationsgräben auf, um die Transistorstrukturen voneinander und von weiteren Bauelementen zu entkoppeln.

Über der oben liegenden Siliziumschicht, dem STI-Material der Isolationsgräben und den Transistorstrukturen ist beispielsweise eine Siliziumoxinitridschicht (SiON) abgeschieden, die in nachfolgenden Ätzprozessen als Stoppschicht verwendet wird. Ferner können zwischen dieser Ätzstoppschicht und der oben liegenden Siliziumschicht Silizide gebildet sein.

Ferner ist eine TEOS-Schicht (TEOS: Tetraethylorthosilikat) als Maskierungsschicht abgeschieden. Nachdem die Transistorstrukturen und der Kontaktstapel aus Siliziumoxinitrid (SiON) und Tetraethylorthosilikat (TEOS) gebildet worden sind, wird dann eine Fotolackschicht strukturiert, um eine Rückseitenkontaktmaske mit einer Öffnung zum Ätzen eines Kontaktes des rückwärtigen Siliziumsubstrats bereitzustellen.

Ist das Rückseitenkontaktmaskenstrukturmuster in der Fotolackschicht einmal definiert, wird der Stapel aus Tetraethylorthosilikat (TEOS), Siliziumoxinitrid (SiON), STI-Material und vergrabenem Oxid bis auf das rückwärtige Siliziumsubstrat heruntergeätzt. Durch diesen Ätzvorgang wird ein Kontaktloch gebildet. Das STI-Material des Isolationsgrabens ist durch die Bildung des Kontaktloches geteilt worden. Der Fotolack wird nun durch einen Plasmastrip und einen zusätzlichen nasschemischen Reinigungsschritt entfernt.

Ist das rückwärtige Kontaktloch einmal gebildet, findet die Bildung der Kontakte zum Verbinden der Transistorstrukturen statt. Dies wird einen anderen Fotolackschichtstrukturierungsprozess und einen getrennten Ätzschritt erfordern.

Der zuvor beschriebene Stand der Technik ist beispielsweise der DE 100 54 109 A1 entnehmbar. Ergänzend wird auf US 5,965,917 A hingewiesen, die sich ebenfalls mit der Problematik der Substratkontaktierung bei SOI-Strukturen befasst. Aus der US 2003/0094654 A1 sind zwei leitfähige, von einer vergrabenen Oxidschicht voneinander isolierte Substratschichten als Leitungsschienen bekannt, die jeweils durch einen tiefen Graben kontaktiert sind.

Aus der EP 1 120 835 A2 ist eine Durchkontaktierung durch eine vergrabene isolierende Schicht in ein Halbleiter-Substrat bekannt. Dabei verbindet die Durchkontaktierung die Sourceregion eines Feldeffekttransistors mit dem unterhalb der vergrabenen isolierenden Schicht ausgebildeten Halbleitersubstrat. Auch aus der DE 103 03 643 B3 ist ein Verfahren zur Herstellung von Substratkontakten bei SOI-Schaltungsstrukturen bekannt. Dabei sind mehrere Schichtfolgen einander überdeckende Metallisierungsschichten im Bereich der Kontaktierung ausgebildet. Eine Kontaktierung eines Siliziumsubstrats in einem dotierten Gebiet mittels Polysilizium ist hingegen in der WO 02/073667 A2 offenbart.

Aus der US 6,372,562 B1 ist eine Kontaktierung eines Substratbereiches durch eine dielektrische Schicht hindurch bekannt, wobei der kontaktierte Substratbereich durch einen in Sperrrichtung gepolten PN-Übergang von einem weiteren Substratbereich isoliert ist. Ebenfalls in der GB 2 346 260 A wird ein Verfahren zur Erzeugung eines Kontakts zu einem durch einen PN-Übergang isolierten Substratbereich in einem tiefen Graben eines SOI-Bauteils offenbart. Aus der EP 0 635 884 A1 ist ein Verfahren zur Herstellung eines Grabens in einem Substrat und dessen Verwendung in der Smart-Power-Technologie bekannt. Dabei wird nach Verstärkung einer Grabenmaske durch eine nicht konform abgeschiedene Schutzschicht in einer zweiten Grabenätzung die vergrabene isolierende Schicht bis auf das Siliziumsubstrat durchgeätzt. Ein weiteres Verfahren zur Herstellung einer Substratkontaktierung ist aus der US 6,632,710 B2 bekannt.

Der Erfindung liegt die Aufgabe zu Grunde ein Verfahren zur Herstellung einer Kontaktierung eines leitfähigen Substrats weiter zu entwickeln.

Diese Aufgabe wird erfindungsgemäß durch ein Verfahren mit den Merkmalen des Anspruchs 1 gelöst. Bevorzugte Weiterbildungen der Erfindung sind Gegenstand von Unteransprüchen.

Demgemäß ist ein Verfahren zur Herstellung einer Halbleiteranordnung vorgesehen. Bei diesem Verfahren werden ein leitfähiges Substrat, ein Bauelementebereich und eine den Bauelementebereich von dem leitfähigen Substrat isolierende Isolatorschicht ausgebildet. Ein derartiger Aufbau wird auch als SOl-Struktur (engl. Silicon-On-Insulator) bezeichnet. Der Bauelementebereich weist vorzugsweise einen monokristallinen Halbleiter zur Ausbildung von Halbleiterbauelementen auf.

Ein Graben wird in den Bauelementebereich bis zur Isolatorschicht durch das Halbleitermaterial des Bauelementebereichs geätzt. Die Ätzung erfolgt dabei vorzugsweise selektiv gegenüber Oxidschichten. Weiterhin wird vorzugsweise eine Ätzung verwendet, die ein hohes Aspektverhältnis von Tiefe zu Breite der Ätzung ermöglicht.

Anschließend wird der tiefe Graben bis zum leitfähigen Substrat weiter geätzt. Dieser Ätzschritt erfolgt vorzugsweise gegenüber Halbleiterschichten selektiv. Anschließend werden die Wände des Grabens mit einem Isolationsmaterial ausgebildet. Zur Ausbildung des Isolationsmaterials kann auf die Wandbereiche des Grabens beispielsweise ein Oxid abgeschieden werden. Bevorzugt wird zur Ausbildung des Isolationsmaterials jedoch ein an den Graben angrenzender Siliziumbereich des Bauelementebereichs oxidiert. Vorzugsweise grenzt das Isolationsmaterial dabei an die vergrabene Isolatorschicht.

Nach den Ätzschritten wird vorzugsweise ein elektrischer Leiter in den durch das Isolationsmaterial gegenüber dem Halbleitermaterial des Bauelementebereichs isolierten Graben eingebracht. Dabei wird der elektrische Leiter vorzugsweise mit dem leitfähigen Substrat leitend verbunden.

Vor dem Ätzen des Grabens wird eine Schichtenfolge aus einer ersten Oxidschicht, einer Polysiliziumschicht oberhalb der ersten Oxidschicht und einer zweiten Oxidschicht oberhalb der Polysiliziumschicht auf den Bauelementebereich aufgebracht. Die Schichtenfolge soll als Maskierung einen Oberflächenbereich außerhalb des zu ätzenden tiefen Grabens gegen die Ätzangriffe schützen.

Gemäß einer bevorzugten Ausgestaltung ist vorgesehen, dass die Schichtenfolge lithographisch derart strukturiert wird, dass eine vertikale Öffnung in die Schichtenfolge eingebracht wird, wobei durch diese vertikale Öffnung der Graben tief geätzt wird. Die Öffnung wird dabei vorzugsweise in einer Vertiefung in einer Oberfläche des Bauelementebereichs positioniert, um die Öffnung zum Bauelementebereich zu justieren. Zur lithographischen Strukturierung kann beispielsweise ein an sich bekannter Photolack aufgebracht und mit einer Maske belichtet werden. Nachfolgend wird die Öffnung in die Schichtenfolge geätzt.

In einer anderen vorteilhaften Weiterbildungsvariante der Erfindung wird die zweite Oxidschicht zeitgleich mit der, im Graben offen liegenden vergrabenen Isolatorschicht geätzt. Die Ätzung wird daher an beziehungsweise in der Polysiliziumschicht als auch am beziehungsweise im Halbleitermaterial des Substrats gestoppt.

In einer anderen vorteilhaften Weiterbildungsvariante der Erfindung ist vorgesehen, dass die Polysiliziumschicht im Schritt zur Ausbildung des Isolationsmaterials mit oxidiert wird und somit die erste Oxidschicht in ihrer Dicke verstärkt. Bevorzugt ist dabei vorgesehen, dass auf einen Boden des Grabens eine Oxidschicht ausgebildet wird. Die oxidierte Polysiliziumschicht bildet zusammen mit der ersten Oxidschicht eine Siliziumdioxid-Deckschicht, die dicker ist als die den Boden bedeckende Oxidschicht. Vorteilhafterweise wird bei einer nachfolgenden Ätzung der Oxidschicht, die den Boden bedeckt, die Siliziumdioxid-Deckschicht nicht vollständig abgetragen, so dass diese gedünnt als Isolatorschicht verbleibt.

Weiterhin ist bevorzugt vorgesehen, dass zur leitenden Verbindung des elektrischen Leiters mit dem leitfähigen Substrat die Oxidschicht als Isolationsmaterial, die den Boden des Grabens bedeckt, entfernt wird. Zur Entfernung wird diese den Boden bedeckende Oxidschicht mittels eines Plasmaätzschrittes (ICP; engl. inductive-coupled-plasma) im Wesentlichen in vertikaler Richtung entfernt. Isolationsmaterial an den Seitenwänden des tiefen Grabens bleibt dagegen für Isolationszwecke erhalten. Bevorzugt wird daher zur Ausbildung des Isolationsmaterials ein an den Graben angrenzender Siliziumbereich des Bauelementebereichs zu einer Oxidschicht oxidiert.

In einer vorteilhaften Weiterbildungsvariante der Erfindung ist vorgesehen, dass eine Menge von Bauelementen in dem Bauelementebereich nach der Ausbildung des Isolationsmaterials ausgebildet wird. Das thermische Budget zur Ausbildung der Bauelemente im Bauelementebereich kann daher Unabhängig von der Ausbildung des tiefen Graben erfolgen. Wird in den tiefen Graben ein Leiter aus Polysilizium eingebracht, kann dies vorteilhafterweise ebenfalls vor der Ausbildung der Halbleiterbauelemente erfolgen. Die Menge der Bauelemente ist dabei gegenüber einem oder mehreren Substratbereichen in vertikaler Richtung durch die vergrabene Isolatorschicht isoliert. Weiterhin ermöglicht das Isolatormaterial in den tiefen Gräben eine laterale Isolation von zumindest zwei Bauelementen.

Die Erfindung bevorzugt weiterbildend wird zeitgleich zum Ätzen des Grabens zur Aufnahme des Leiters ein lsoliergraben geätzt, wobei der Isoliergraben mit einem Isolator vollständig verfüllt wird und ausschließlich der Isolation eines Bauelementes dient. Dies ermöglicht eine Reduktion der Anzahl der benötigten Ätzschritte insbesondere in das Halbleitermaterial des Bauelementebereichs. Zudem wird die Positionierungsgenauigkeit des tiefen Grabens für den Leiter zur Kontaktierung des Substrats und der weiteren tiefen Gräben zueinander verbessert.

Vorteilhafte Ausgestaltungen der Erfindung sehen vor, dass für den elektrischen Leiter hochdotiertes Halbleitermaterial und/oder Metall und/oder Silizid eingebracht wird.

Gemäß einer anderen vorteilhaften Weiterbildungsvariante wird der Graben innerhalb einer Vertiefung in einer Oberfläche ausgebildet. Dabei werden in die Vertiefung die erste Oxidschicht, die Polysiliziumschicht und die zweite Oxidschicht aufgebracht. Die Vertiefung kann beispielsweise als flacher Graben (STI engl. Shallow Trench Isolation) ausgebildet werden.

Gemäß einer anderen vorteilhaften Weiterbildungsvariante wird das leitfähige Substrat mit einer Anzahl von voneinander isolierten Substratbereichen ausgebildet. Diese Substratbereiche können beispielsweise durch eine tiefe Grabenätzung voneinander getrennt werden. Vorzugsweise werden diese tiefen Gräben dann mit einem Dielektrikum verfüllt. Jeder Substratbereich kann dabei unabhängig voneinander an ein separates, festes oder variables Potential angelegt werden, so dass getrennte Bauelemente im Bauelementebereich mit unterschiedlichen, angelegten Substratpotentialen betrieben werden können. Bevorzugt ist dabei vorgesehen, dass die voneinander isolierten Substratbereiche jeweils mit zumindest einem in einem Graben angeordneten elektrischen Leiter leitend verbunden werden. Zusätzlich kann auch ein nicht kontaktierter Substratbereich ausgebildet werden.

Ein anderer Aspekt der Erfindung ist eine Verwendung eines zuvor beschriebenen Verfahrens zur Herstellung eines Schaltkreises. Dieser Schaltkreis weist Mittel auf an den elektrischen Leiter der Halbleiteranordnung ein konstantes oder steuerbares Potential anzulegen. Dabei ist von dem konstanten oder steuerbaren Potential zumindest eine elektrische Eigenschaft des Bauelementes abhängig.

Weiterhin ist ein Gegenstand der Erfindung eine Halbleiteranordnung, die mittels des zuvor erläuterten Verfahrens hergestellt ist. Diese Halbleiteranordnung weist einen Bauelementebereich, ein leitfähiges Substrat und eine vergrabene Isolatorschicht auf, wobei die Isolatorschicht den Bauelementebereich gegenüber dem leitfähigen Substrat isoliert. Die Halbleiteranordnung weist zumindest einen, mit einem Isolationsmaterial gefüllten Graben, der zumindest ein Bauelement im Bauelementebereich von weiteren Bauelementen im Bauelementebereich isoliert, auf. Ein elektrischer Leiter ist mit dem leitfähigen Substrat leitend verbunden. Der elektrische Leiter ist durch das Isolationsmaterial isoliert innerhalb des Grabens angeordnet. Vorzugsweise ist der Graben dabei innerhalb einer Vertiefung in der Oberfläche ausgebildet.

Die Kontaktierung des leitfähigen Substrats kann dabei unterschiedlichen Funktionen dienen. Eine wichtige Funktion ist es, die Bauelementeparameter von auf der gegenüberliegenden Seite der vergrabenen Isolatorschicht angeordneten Bauelementen durch die Höhe oder den zeitlichen Verlauf des angelegten Substratpotentials zu verändern. Insbesondere kann die Durchbruchsspannung eines lateralen N-DMOS-Transistors verbessert werden. Weiterhin kann durch die Höhe eines angelegten Substratpotentials eine Stromverstärkung eines NPN-Bipolartransistors verändert, insbesondere vergrößert werden. Dabei ist eine deutliche Verbesserung für positive Substratpotentiale zu erreichen. Weiterhin kann das Substrat zudem als Leitungsverbindung zu einem anderen Bauelement oder zu einem auf der Rückseite angeordneten Kontakt der integrierten Schaltung genutzt werden. Ebenso ist es möglich durch ein Einbringen von Dotanden in das Substrat, Halbleiterbauelemente, wie beispielsweise Dioden im Substrat auszubilden.

Ein weiterer Aspekt der Erfindung ist ein Schaltkreis mit einer zuvor beschriebenen Halbleiteranordnung. Diese Halbleiteranordnung weist vorzugsweise einen lateralen DMOS-Feldeffekttransistor auf. An den elektrischen Leiter ist ein konstantes oder steuerbares Potential angelegt, von dem zumindest eine elektrische Eigenschaft des Bauelementes abhängig ist.

Die zuvor beschriebenen Weiterbildungsvarianten und Ausgestaltungen sind sowohl einzeln als auch in Kombination besonders vorteilhaft. Dabei können sämtliche Weiterbildungsvarianten und/oder Ausgestaltungen untereinander kombiniert werden. Eine mögliche Kombination ist in der Beschreibung des Ausführungsbeispiels in den Figuren erläutert. Diese dort dargestellte Kombinationsmöglichkeit der Weiterbildungsvarianten und Ausgestaltungen ist jedoch nicht abschließend.

Im Folgenden wird die Erfindung in einem Ausführungsbeispiel anhand einer Zeichnung mit den Figuren 1 bis 8 näher erläutert.

Dabei zeigen
- Fig. 1 bis Fig. 7: schematische Schnittansichten durch einen Wafer zu unterschiedlichen Prozesszeitpunkten der Herstellung einer Halbleiteranordnung, und
- Fig. 8: eine schematische Schnittansicht eines LDMOS-Feldeffekttransistors mit einer Verbindung zum Substrat.

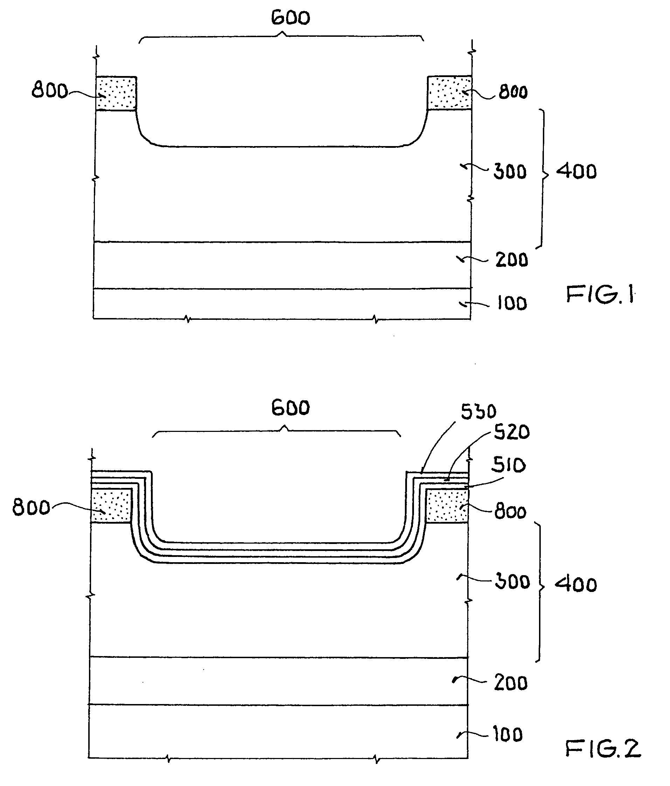

In den Figuren 1 bis 8 sind schematische Schnittansichten durch einen Wafer zu unterschiedlichen Prozesszeitpunkten der Herstellung einer Halbleiteranordnung dargestellt. Gleiche Strukturelemente sind in der Regel mit gleichen Bezugszeichen versehen.

In Fig. 1 ist ein Bauelementebereich 400 aus Silizium 300 als Halbleitermaterial, ein leitfähiges, n-dotiertes Siliziumsubstrat 100 und eine vergrabene Isolatorschicht 200 dargestellt. Die Isolatorschicht 200 isoliert den Bauelementebereich 400 von dem Siliziumsubstrat 100. Die Isolatorschicht 200 ist ein Dielektrikum beispielsweise aus Siliziumdioxid (SiO₂). Auf das Silizium 300 des Bauelementebereichs 400 ist zur Maskierung eine Hartmaske 800 aus Siliziumnitrid (Si₃N₄) aufgebracht. Ein flacher Graben 600 (STI) ist in das Silizium 300 geätzt, wobei Bereiche zur Ausbildung von Bauelementen durch die Hartmaske 800 vor dem Ätzangriff geschützt sind.

In Fig. 2 ist innerhalb des geätzten Grabens 600 und auf der Hartmaske 800 eine Schichtenfolge aus einer ersten Siliziumdioxidschicht 510 (SiO₂), einer Schicht aus polykristallinem Silizium 520 (Poly-Si) und einer zweiten Siliziumdioxidschicht 530 (SiO₂) aufgebracht. Diese Schichtenfolge 510, 520, 530 wird auch als OPO-Schicht bezeichnet. Vorzugsweise werden diese Schichten 510, 520, 530 nacheinander, aufeinander folgend abgeschieden.

Die Schichtenfolge aus den Schichten 510, 520, 530 wird mittels eines Photolacks und einer Maske lithographisch derart strukturiert, dass eine vertikale Öffnung in die Schichtenfolge eingebracht wird. Hierbei wird durch eine Lacköffnung in der Photolackmaskierung zuerst die zweite Oxidschicht, dann die polykristalline Siliziumschicht und nachfolgend die erste Oxidschicht geätzt. Durch diese vertikale Öffnung im Schichtstapel wird ein tiefer Graben 700 (engl. Deep Trench) in das Halbleitermaterial 300 des Bauelementebereichs 400 geätzt. Diese Ätzung ist selektiv gegenüber der zweiten Oxidschicht 530 und trägt dabei im Wesentlichen nur das Silizium 300 bis zur vergrabenen Isolatorschicht 200 ab. Hiernach wird das vergrabene Oxid 200 unterhalb der geätzten Öffnung entfernt. Zugleich wird auch die zweite Oxidschicht 530 mit entfernt. Fig. 3 zeigt den Zustand nach der Ätzung der zweiten Oxidschicht und des vergrabenen Oxids 200 unterhalb der geätzten Öffnung. Der tiefe Graben 700 weist Grabenwände 701 und einen Grabenboden 702 auf.

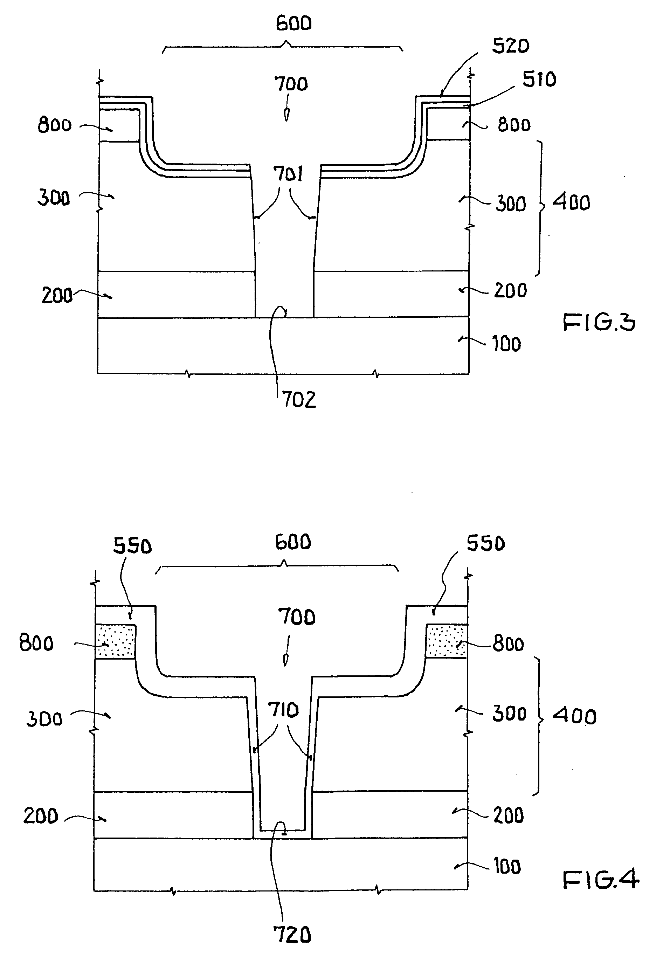

Nachfolgend wird im nächsten Prozessschritt ein thermisches Oxid in hoher Qualität, vorzugsweise mit einer Dicke von 50 nm hergestellt. Dabei wird an den Grabenwänden 701 und am Grabenboden 702 eine Oxidschicht 710 respektive 720 gebildet. Dieser Zustand ist in Fig. 4 schematisch dargestellt. Dabei wird Silizium-Material des Bauelementebereichs 400 im Wandungsbereich und Silizium-Material des Siliziumsubstrats 100 in Siliziumdioxid umgewandelt. Weiterhin wird die Polysiliziumschicht 520 ebenfalls in Siliziumdioxid umgewandelt, so dass zusammen mit der ersten Oxidschicht 510 eine Siliziumdioxid-Deckschicht 550 gebildet wird, die dicker ist als die Oxidschicht 720 am Boden 702 des Grabens 700.

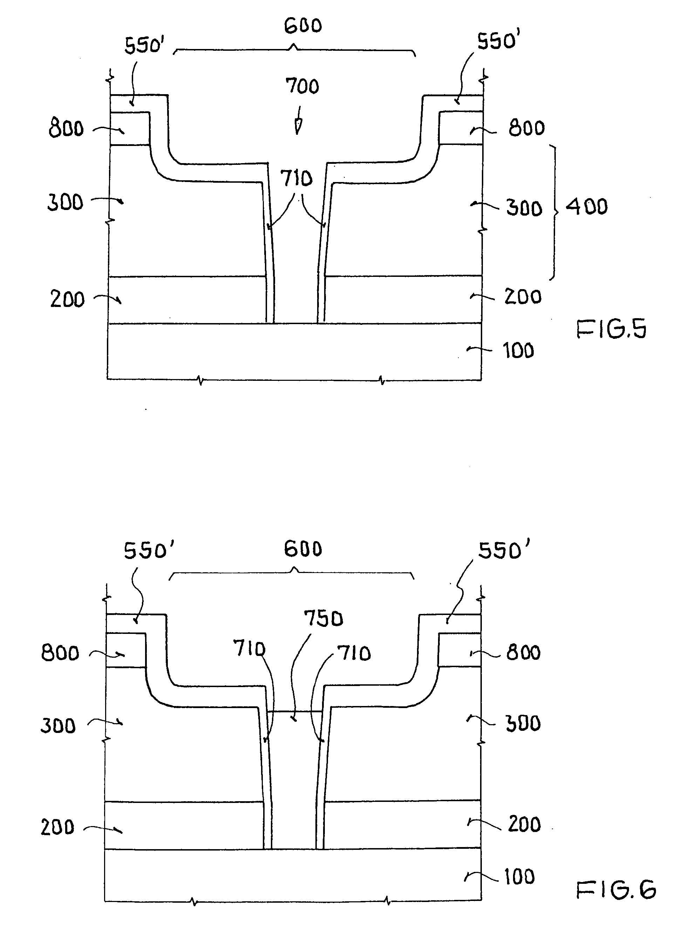

Im nächsten Prozessschritt wird mittels einer anisotropen Ätzung das Oxid 720 am Boden des tiefen Grabens 700 abgeätzt. Dieser Prozesszustand ist in Fig. 5 dargestellt. Dabei wird die Siliziumdioxid-Deckschicht 550' entsprechend gedünnt, verbleibt jedoch als Isolator vorhanden. Gleiches gilt für die Oxidschicht 710 an den Wänden 701 des Grabens 700, die ebenfalls lediglich gedünnt wird und als Isolator verbleibt.

Anschließend wird konform Polysilizium 750 oder amorphes Silizium 750 auf dem Wafer abgeschieden und bis zum Eingang des tiefen Grabens 700 zurückgeätzt. Dieser Zustand ist in Fig. 6 dargestellt. Das Polysilizium 750 kann entweder bereits während der Abscheidung oder bei der späteren Kontaktöffnung durch Implantation dotiert werden. Der Dotierungstyp entspricht vorteilhafterweise dem des Siliziumsubstrats 100.

Nachfolgend wird der flache Graben 600 mit Oxid 580 gefüllt, die Hartmaske (800) entfernt und die Waferoberfläche beispielsweise mittels chemischmechanischem Polierens (CMP) planarisiert. Die nächsten Verfahrensschritte dienen der Herstellung der Halbleiterbauelemente im Bauelementebereich 400. Die Kontaktierung des Siliziumsubstrats 100 durch den tiefen Graben 700 (Kontaktgraben) wird erst nach Fertigstellung aller Bauelemente weiter prozessiert.

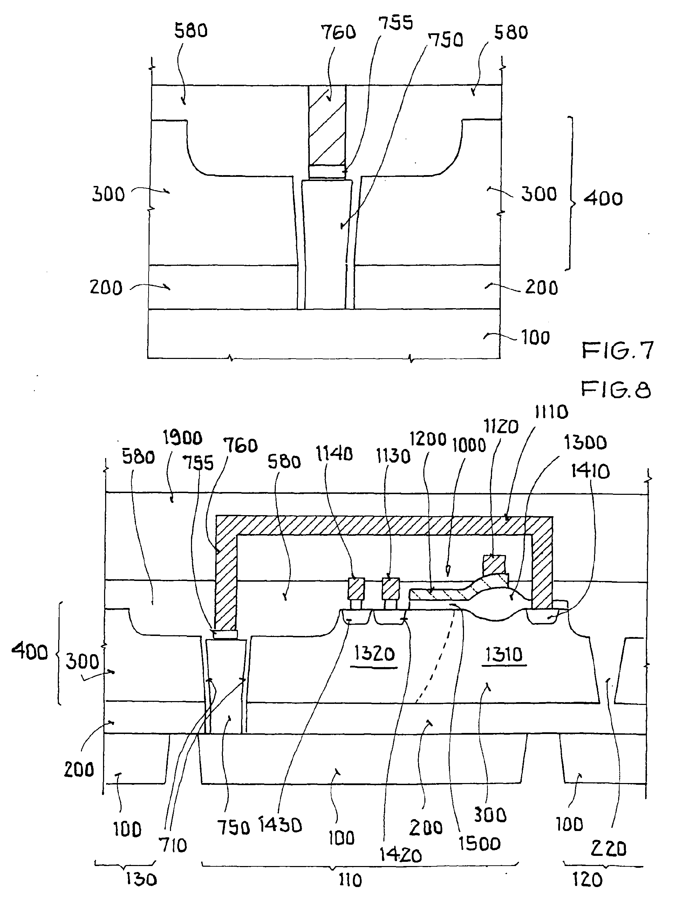

Zur Kontaktierung der Polysiliziumfüllung 750 wird das Oxid 580 im flachen Graben 600 in einem lithographisch maskierten Ätzschritt über dem Polysilizium 750 entfernt. Die geätzte Oxidöffnung wird nun mit einer Diffusionsbarriere 755, beispielsweise aus einem Silizid und mit einem Metall 760, beispielsweise Wolfram gefüllt. Dieser Prozesszustand ist in Fig. 7 dargestellt.

Die Fig. 8 zeigt eine schematische Schnittansicht durch einen Wafer mit einem Leistungsbauelement 1000, das im Bauelementebereich 400 aufgebildet ist, und eine Kontaktierung des Siliziumsubstrats 100. Das Siliziumsubstrat 100 ist dabei in mehrere Substratbereiche 110, 120, 130 durch geätzte Gräben unterteilt. Ein Substratbereich 110 ist dabei unterhalb des Leistungsbauelementes 1000 ausgebildet. Das Leistungsbauelement 1000 ist durch den mit dem Polysilizium 750 gefüllten tiefen Graben (700) und durch zumindest eine weitere Grabenisolation 220 von benachbarten Bauelementen (in Fig. 8 nicht dargestellt) durch ein Dielektrikum 710, 220 insbesondere aus Siliziumdioxid isoliert.

Im Ausführungsbeispiel der Fig. 8 ist das Leistungsbauelement 1000 ein N-DMOS-Feldeffektransistor 1000. Dieser weist ein n-dotiertes Drainhalbleitergebiet 1410, eine N-Wanne 1310, die eine Driftzone ausbildet, eine P-Wanne 1320, die ein Bodyhalbleitergebiet ausbildet, ein n-dotiertes Sourcehalbleitergebiet 1420 und ein p-dotiertes Bodyanschlusshalbleitergebiet 1430 auf. Weiterhin weist der N-DMOS-Feldeffekttransistor 1000 ein Feld-Oxid 1300 und ein Gate-Oxid 1500 mit einer darauf angeordneten Gate-Elektrode 1200 aus Polysilizium auf. Drainhalbleitergebiet 1410, Gate-Elektrode 1200, Sourcehalbleitergebiet 1420 und Bodyanschlusshalbleitergebiet 1430 sind mit jeweils eine Metallleiterbahn 1110, 1120, 1130 und 1140 leitend verbunden. In dem Ausführungsbeispiel der Fig. 8 ist der Substratbereich 110 über das Polysilizium 750, die Diffusionsbarriere 755, das Metall 760 und die Leiterbahn 1110 mit dem Drainhalbleitergebiet 1410 verbunden, so dass der Substratbereich 110 im Wesentlichen dasselbe Potential wie das Drainhalbleitergebiet 1410 aufweist. Der Wafer ist durch ein Bor-Phosphor-Silicat-Glas 1900 gegen äußere Einflüsse geschützt.

Alternativ zur Fig. 8 kann der Substratbereich 110 auch an ein anderes Bauelement zur Steuerung des Potentials des Substratbereichs 110 angeschlossen sein. Eine weitere Möglichkeit besteht darin, den Substratbereich 110 beispielsweise mittels eines Spannungsteilers aus zwei Kondensatoren an ein festes Potential anzuschließen.

Die Erfindung ist selbstverständlich nicht auf das dargestellte Ausführungsbeispiel beschränkt, sondern umfasst auch nicht dargestellte Ausführungsvarianten. Beispielsweise könnten das im Ausführungsbeispiel dargestellte Aspektverhältnis des flachen Grabens 600 und des tiefen Grabens 700 auch anders ausgebildet werden. Auch ist es möglich ein metallisches Substrat zu verwenden. Ebenfalls ist die Erfindung nicht auf das in Fig. 2 dargestellt Leistungsbauelement 1000 beschränkt. Sie schützt auch jedes Verfahren, dass von der OPO-Schichtenfolge 510, 520, 530 zur Strukturierung des tiefen Grabens 700 und in Doppelfunktion zur Isolation insbesondere des flachen Grabens 600 gebrauch macht.

### Bezugszeichenliste

- 100: Siliziumsubstrat
- 110, 120, 130: Substratbereich
- 200: vergrabene Isolatorschicht, SiO₂
- 220: mit Dielektrikum verfüllter tiefer Graben
- 300: monokristallines Siliziumkristall
- 400: Bauelementebereich
- 510: erste Oxidschicht
- 520: Polysiliziumschicht
- 530: zweite Oxidschicht
- 550, 550': Oxidschicht
- 580: Dielektrikum, Siliziumdioxid
- 600: flacher, geätzter Graben
- 700: tiefer Graben, geätzt
- 701: Wandung des tiefen Grabens
- 702: Boden des tiefen Grabens
- 710: Isoliermaterial, Siliziumdioxid
- 720: Isoliermaterial, Siliziumdioxid
- 750: dotierte Polysiliziumfüllung
- 755: Diffusionsbarriere, Silizid
- 760: Metall, Wolfram, Aluminium
- 800: Hartmaske, Si₃N₄
- 1000: Bauelement, N-DMOS-Feldeffekttransistor
- 1110, 1120, 1130, 1140: Metallisierung, Leiterbahn
- 1200: Gate-Elektrode, polykristallines Silizium
- 1300: Feld-Oxid
- 1310: N-Wanne, Driftzone
- 1320: P-Wanne, Body
- 1410: Drainhalbleitergebiet
- 1420: Sourcehalbleitergebiet
- 1430: Bodyanschlusshalbleitergebiet
- 1500: Gate-Oxid
- 1900: Bor-Phosphor-Silicat-Glas

## Patentansprüche

1. Verfahren zur Herstellung einer Halbleiteranordnung, bei dem
- ein leitfähiges Substrat (100), ein Bauelementebereich (400) und eine den Bauelementebereich (400) von dem leitfähigen Substrat (100) isolierende Isolatorschicht (200) ausgebildet wird,
- ein Graben (700) in den Bauelementebereich (400) bis zur Isolatorschicht (200) geätzt wird,
- anschließend der Graben (700) bis zum leitfähigen Substrat (100) weiter geätzt wird,
- die Wände (701) des Grabens (700) mit einem Isolationsmaterial (710) ausgebildet werden, und
- ein elektrischer Leiter (750, 755, 760) in den Graben (700) eingebracht und mit dem leitfähigen Substrat (100) leitend verbunden wird,
wobei
- vor dem Ätzen des Grabens (700) eine Schichtenfolge aus einer ersten Oxidschicht (510), einer Polysiliziumschicht (520) oberhalb der ersten Oxidschicht (510) und einer zweiten Oxidschicht (530) oberhalb der Polysiliziumschicht (520) auf den Bauelementebereich (400) aufgebracht wird.

2. Verfahren nach Anspruch 1, bei dem die Schichtenfolge (510, 520, 530) lithographisch derart strukturiert wird, dass eine vertikale Öffnung in die Schichtenfolge (510, 520, 530) eingebracht wird, wobei durch diese vertikale Öffnung der Graben (700) tief geätzt wird.

3. Verfahren nach einem der Ansprüche 1 oder 2, bei dem die zweite Oxidschicht (530) zeitgleich mit der, im Graben (700) offenliegenden vergrabenen Isolatorschicht (200) geätzt wird.

4. Verfahren nach einem der vorhergehenden Ansprüche, bei dem die Polysiliziumschicht (520) im Schritt zur Ausbildung des Isolationsmaterials (710) oxidiert wird.

5. Verfahren nach Anspruch 4, bei dem auf einen Boden (702) des Grabens (700) eine Oxidschicht (720) ausgebildet wird, und bei dem die oxidierte Polysiliziumschicht zusammen mit der ersten Oxidschicht (510) eine Siliziumdioxid-Deckschicht (550) bildet, die dicker ist als die den Boden (702) bedeckende Oxidschicht (720).

6. Verfahren nach Anspruch 5, bei dem zur leitenden Verbindung des elektrischen Leiters (750) mit dem leitfähigen Substrat (100) die Oxidschicht (720), die den Boden (702) des Grabens (700) bedeckt, entfernt wird.

7. Verfahren nach einem der vorhergehenden Ansprüche, bei dem zur Ausbildung des Isolationsmaterials (710) ein an den Graben (700) angrenzender Siliziumbereich (300) des Bauelementebereichs (400) zu einer Oxidschicht (710) oxidiert wird.

8. Verfahren nach einem der vorhergehenden Ansprüche, bei dem eine Menge von Bauelementen (1000) in dem Bauelementebereich (400) nach der Ausbildung des Isolationsmaterials (710) ausgebildet wird.

9. Verfahren nach einem der vorhergehenden Ansprüche, bei dem zeitgleich zum Ätzen des Grabens (700) zur Aufnahme des Leiters (750) ein Isoliergraben geätzt wird, wobei der Isoliergraben mit einem Isolator (220) vorzugsweise vollständig verfüllt wird und ausschließlich der Isolation des Bauelementes (1000) dient.

10. Verfahren nach einem der vorhergehenden Ansprüche, bei der für den elektrischen Leiter hochdotiertes Halbleitermaterial (750) und/oder Metall (760) und/oder Silizid (755) eingebracht wird.

11. Verfahren nach einem der vorhergehenden Ansprüche, bei der der Graben (700) innerhalb einer Vertiefung (600) in einer Oberfläche ausgebildet wird, wobei in die Vertiefung die erste Oxidschicht (510), die Polysiliziumschicht (520) und die zweite Oxidschicht (530) aufgebracht werden.

12. Verwendung eines Verfahrens nach einem der vorhergehenden Ansprüche zur Herstellung eines Schaltkreises, der Mittel aufweist an dem elektrischen Leiter der Halbleiteranordnung ein konstantes oder steuerbares Potential anzulegen, wobei von dem konstanten oder steuerbaren Potential zumindest eine elektrische Eigenschaft des Bauelementes abhängig ist.
